# EUROPEAN PATENT SPECIFICATION

(11) **EP 3 418 313 B1**
(45) Date of publication and mention of the grant of the patent: **02.09.2020**
(21) Application number: 17753191.0
(22) Date of filing: 15.02.2017
(51) Int. Cl.: C08G 59/42, C08L 25/08, C08L 63/00, G03F 7/029, B29C 64/106, B29C 64/141

(54) **COMPOSITION OPTICAL THREE-DIMENSIONAL MOLDING**
ZUSAMMENSETZUNG FÜR OPTISCHES DREIDIMENSIONALES FORMEN
COMPOSITION DE MOULAGE TRIDIMENSIONNEL OPTIQUE

(30) Priority: 15.02.2016 JP 2016026164
(43) Date of publication of application: 26.12.2018
(73) Proprietor: Okamoto Chemical Industry Co., Ltd, Warabi-shi, Saitama 335-0004 (JP)
(72) Inventor: OKAMOTO, Hiroaki, Warabi-shi Saitama 335-0004 (JP); NAKATSUKA, Masaro, Warabi-shi Saitama 335-0004 (JP)
(74) Representative: HGF
(86) International application number: PCT/JP2017/005413
(87) International publication number: WO 2017/141935

(56) References cited:
- WO-A1-2009/070500
- WO-A1-2015/037574
- WO-A1-2015/080159
- WO-A1-2016/163283
- WO-A2-2010/104603
- CN-A- 104 693 637
- JP-A- H0 411 626
- JP-A- S5 016 864
- JP-A- H04 314 721
- JP-A- H07 233 319
- JP-A- H10 168 106
- JP-A- H11 228 804
- JP-A- 2004 300 204
- JP-A- 2009 138 017
- JP-A- 2013 023 574

## Description

### TECHNICAL FIELD

The present invention relates to a composition for optical stereolithography.

### BACKGROUND ART

Recently, optical stereolithographic techniques have attracted attention for the fabrication of a stereolithographic object based on three-dimensional CAD data by forming and stacking cured layers one by one by curing a photo-curable resin through ultraviolet laser scanning. Since the optical stereolithographic technique (hereinafter, the term "optical stereolithography" will also be referred to as "stereolithography") enables easy and quick fabrication of prototypes without preparing a die or a mold, and it is possible to reduce the time and cost required for product development from a design to manufacturing. Along with the rapid spread of three-dimensional CAD, the stereolithographic technique has been employed in a wide variety of industrial fields such as automobile parts, electrical equipment, and medical equipment.

As the fields to which optical stereolithographic techniques are applied are expanding, the photo-curable resins are also required to achieve higher performances. In particular, it is desired to produce photo-curable resins having high curing rates, having excellent dimensional stability and dimensional precision when cured, and being capable of forming stereolithographic objects which have excellent heat resistance and mechanical properties, that is, toughness and durability, that the stereolithographic objects tend not to break even when an external stress, such as bending, is applied thereto.

Along with progress in stereolithographic techniques, there are desired photo-curable resins which can be used in situations requiring higher heat resistance, such as, for example, a stereolithographic object used as an engine part. For example, there have been proposed compositions containing a particular cationic polymerizable organic substance and a particular compound having two oxetanyl groups (for example, Patent Documents 1, 2, and 3). Patent document 4 relates to radiation curable resins suitable for use in forming three-dimensional articles using stereolithography and other processes.

### REFERENCE DOCUMENT LIST

### PATENT DOCUMENTS

Patent Document 1: Japanese Patent Application Publication No. Heisei 11-228804
Patent Document 2: Japanese Patent Application Publication No. 2008-260812
Patent Document 3: Japanese Patent Application Publication No. 2013-023574
Patent Document 4: PCT Patent Application Publication No. WO2010/104603

### SUMMARY OF THE INVENTION

### PROBLEM TO BE SOLVED BY THE INVENTION

In this respect, in producing a stereolithographic object, generally, a composition for optical stereolithography is scanned by an ultraviolet laser so that many thin cured film layers having a thickness of approximately around 20 to 100 microns are formed and stacked one on another to produce the stereolithographic object. In this process, the strength of the stereolithographic object may be adversely affected in some cases unless the thin cured film layers cohere to one another. Further, conventional compositions for optical stereolithography have problems in that a stereolithographic object during production warps and may be caught in the ultraviolet-laser scanning machine in some cases.

Moreover, in order to enhance the heat resistance of a stereolithographic object, it is a common practice to subsequently heat the stereolithographic object at, for example, 60 to 250°C, after the composition is cured by light irradiation (Patent Document 1). However, such a heat treatment decreases work efficiency due to an increase in the number of steps.

Many commercial objects produced by stereolithography have rather complex shapes, but need to be adapted to applications in which the objects need to bear external force and be bent. An object of the present invention is to provide: a composition for optical stereolithography, the composition being capable of completing stereolithography (photo-curing) within a shorter time, and being excellent in mechanical properties (bending strength and bending modulus) after the stereolithography without a heat treatment operation (heating at 60°C or higher).

### MEANS FOR SOLVING THE PROBLEM

Specifically, one embodiment of the present invention makes it possible to provide a composition for optical stereolithography, containing:
(A) a cationic polymerizable epoxy resin that is a novolac epoxy resin and/or an epoxy resin having a structure represented by:
   the following formula (I): 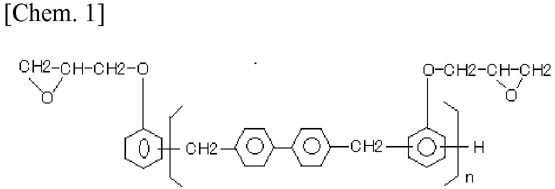 (in the formula, n represents an integer of 1 or more); or
   the following formula (II): 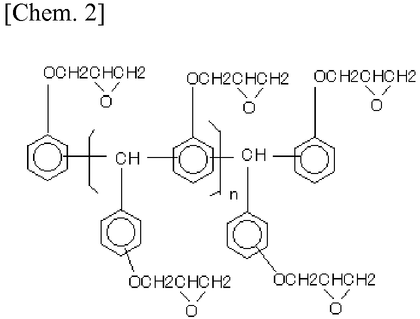 (in the formula, n represents an integer of 1 or more);
(B) a cationic polymerizable compound being other than the component (A) and having a glycidyl ether structure;
(C) a radical polymerizable compound having a methacrylic group and/or an acrylic group;
(D) a styrene-containing copolymer resin that is a copolymer resin of styrene and maleic anhydride, being the copolymer resin in which the repeating unit of the maleic anhydride is half-esterified by ring-opening to form ester and acid, and/or that is a copolymer resin of styrene and methacrylic acid or acrylic acid;
(E) a cationic polymerization initiator which is a sulfonium compound or a bis(alkylphenyl)iodonium compound;
(F) a radical polymerization initiator; and
(G) a sensitizer, in which
   the composition for optical stereo lithography contains:
   5 to 50% by mass of the cationic polymerizable epoxy resin of the component (A),
   5 to 70% by mass of the cationic polymerizable compound of the component (B),
   5 to 50% by mass of the radical polymerizable compound of the component (C),
   1 to 30% by mass of the styrene-containing copolymer resin of the component (D),
   0.1 to 20% by mass of the cationic polymerization initiator of the component (E),
   0.1 to 20% by mass of the radical polymerization initiator of the component (F), and
   0.05 to 5.0% by mass of the sensitizer of the component (G).

### EFFECTS OF THE INVENTION

According to the present invention, it is possible to shorten photo-curing time in production of a stereo lithographic object, and to produce a stereo lithographic object having a small warp deformation and excellent mechanical properties attributed to a phenomenon in which cured film layers cohere to each other in the process of producing the stereo lithographic object.

### MODE FOR CARRYING OUT THE INVENTION

Hereinafter, embodiments of the present invention will be described in detail. However, the scope of the present invention is not limited to these embodiments.

A composition for optical stereolithography at least contains the components (A) to (G) and may further contain other components as needed.

The component (A) is a cationic polymerizable epoxy resin that is a novolac epoxy resin and/or an epoxy resin having a structure represented by
the following formula (I): 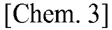 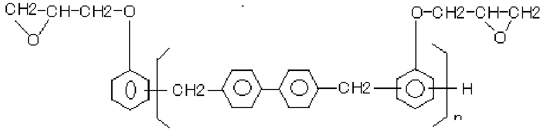 (in the formula, n represents an integer of 1 or more) or
the following formula (II): 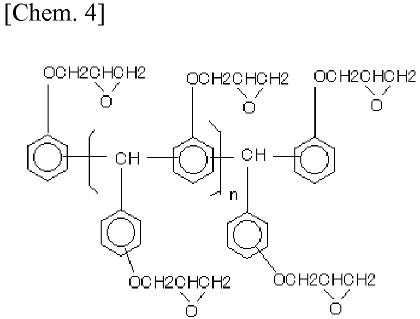 (in the formula, n represents an integer of 1 or more).

The novolac epoxy resin is a multifunctional epoxy resin obtained by epoxidizing a hydroxyl group of novolac, for example, and is generally excellent in heat resistance. The novolac epoxy resin is generally oil-soluble and is preferably liquid at room temperature. The novolac epoxy resin may be, for example, a liquid phenol novolac epoxy resin. The epoxy equivalent of the novolac epoxy resin is preferably 170 to 190 g/eq. A commercially available novolac epoxy resin may be used. Specific examples of the novolac epoxy resin include: EPICLON N-730A (epoxy equivalent: 172 to 179 g/eq) and EPICLON N-770 (epoxy equivalent: 183 to 187 g/eq) manufactured by DIC Corporation; JER 152 (epoxy equivalent: 176 to 178 g/eq) and JER 154 (epoxy equivalent: 176 to 180 g/eq) manufactured by Mitsubishi Chemical Corporation; YDPN-638 (epoxy equivalent: 175 to 176 g/eq), YDCN-700-3 (epoxy equivalent: 195 to 205 g/eq), and YDCN-700-5 (epoxy equivalent: 196 to 206 g/eq) manufactured by NIPPON STEEL & SUMIKIN CHEMICAL CO., LTD.; EOCN-1025 (epoxy equivalent: 205 to 217 g/eq) manufactured by Nippon Kayaku Co., Ltd., etc. Here, the epoxy equivalent refers to the number of grams of a resin containing 1 gram equivalent of an epoxy group, which is measured by a method in accordance with JIS K 7236.

The cationic polymerizable epoxy resin of the component (A) may be an epoxy resin having a structure represented by the following formula (I): 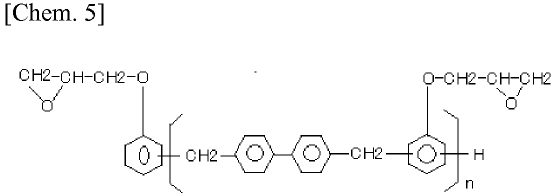 (in the formula, n represents an integer of 1 or more, and is preferably 1 to 3). Specific examples thereof include NC-3000 (epoxy equivalent: 265 to 285 g/eq), NC-3000-L (epoxy equivalent: 261 to 282 g/eq), NC-3000-H (epoxy equivalent: 280 to 300 g/eq), and NC-3100 (epoxy equivalent: 245 to 270 g/eq) manufactured by Nippon Kayaku Co., Ltd., etc.

Instead, the cationic polymerizable epoxy resin of the component (A) may be an epoxy resin having a structure represented by the following formula (II): 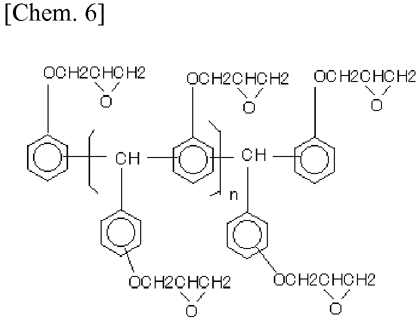 (in the formula, n represents an integer of 1 or more, and is preferably 1 to 2). Specific examples thereof include EPPN-501H (epoxy equivalent: 162 to 172 g/eq), EPPN-501HY (epoxy equivalent: 163 to 175 g/eq), and EPPN-502H (epoxy equivalent: 158 to 178 g/eq) manufactured by Nippon Kayaku Co., Ltd., etc.

The content of the cationic polymerizable epoxy resin of the component (A) is 5 to 50% by mass and preferably 10 to 40% by mass in a total amount of the composition for optical stereolithography. If the content of the cationic polymerizable epoxy resin of the component (A) is less than 5% by mass, a stereolithographic object formed from the composition has insufficient mechanical properties and heat resistance. If the content exceeds 50% by mass, the stereolithographic object has insufficient toughness. The cationic polymerizable epoxy resin of the component (A) has an epoxy equivalent of 100 to 300 g/eq preferably, and more preferably of 150 to 300 g/eq. When the epoxy equivalent of the component (A) is set within the preferable range, the composition can have a high crosslink density at which a three-dimensional structure is formed more easily in the composition, and a stereolithographic object formed from the composition may achieve the improved mechanical properties. Containing the component (A), the composition enables an obtained stereolithographic object to have further enhanced mechanical properties such as tensile strength, elongation, bending strength, and bending modulus, and also improved heat resistance.

The component (B) is a cationic polymerizable compound being other than the component (A) and having a glycidyl ether structure. Containing the component (B), the composition may improve the flexibility of an obtained stereolithographic object. For example, the solubility of the component (B) in water at normal temperature (25°C) is preferably 5 g/100 ml, more preferably 40 g/100 ml or more, and further preferably 50 g/100 ml or more. The cationic polymerizable compound having a glycidyl ether structure of the component (B) may be an ether derivative of sorbitol. In this case, the sorbitol may be in any one of the D-form and the L-form, or the sorbitol may be a mixture of the D-form sorbitol and the L-form sorbitol.

In the ether derivative of sorbitol having a glycidyl ether structure of the component (B), for example, at least one hydrogen atom of six hydroxy groups of sorbitol represented by the following formula (I): 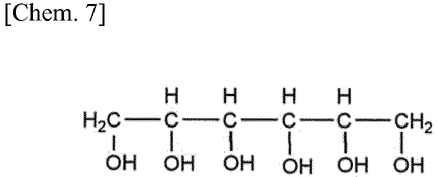 may be substituted with the following glycidyl group:

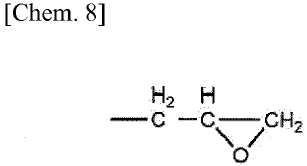

Alternatively, in the ether derivative of sorbitol having a glycidyl ether structure of the component (B), for example, at least one hydrogen atom of the six hydroxy groups of the sorbitol may be substituted with the following glycidyl polyoxyethylene group: 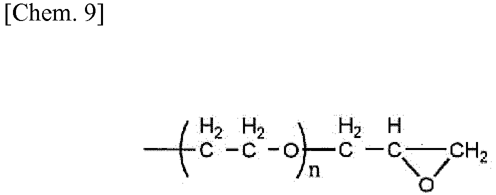 (in the formula, n independently represents an integer of 1 to 50). Alternatively, in the ether derivative of sorbitol having a glycidyl ether structure of the component (B), at least one hydrogen atom of the six hydroxy groups of the sorbitol may be substituted with a glycidyl group, whereas at least one hydrogen atom of the other hydroxy groups of the sorbitol may be further substituted with a glycidyl polyoxyethylene group. The ether derivative of sorbitol having a glycidyl ether structure of the component (B) further substituted with the glycidyl polyoxyethylene group will also be referred to as "glycidyl ether of polyoxyethylene ether of sorbitol."

Specific examples of the cationic polymerizable compound having a glycidyl ether structure of the component (B) include polyglycerol polyglycidyl ether, glycerol polyglycidyl ether, diethylene glycol diglycidyl ether, polyethylene glycol #200 diglycidyl ether, polyethylene glycol #400 diglycidyl ether, and other polyethylene glycol diglycidyl ethers; ethylene glycol diglycidyl ether, propylene glycol diglycidyl ether, tripropylene glycol diglycidyl ether, polypropylene glycol #400 diglycidyl ether, and other polypropylene glycol diglycidyl ethers; polytetramethylene glycol diglycidyl ether, neopentyl glycol diglycidyl, 1,6-hexanediol diglycidyl ether, hydrogenated bisphenol A diglycidyl ether, diglycerol polyglycidyl ether, trimethylolpropane polyglycidyl ether, bisphenol A-PO 2 mol added diglycidyl ether, and other bisphenol A diglycidyl ethers; bisphenol A epoxy resin (liquid), bisphenol A bis(triethylene glycol glycidyl ether) ether, bisphenol F epoxy resin (liquid), phenol novolac epoxy resin (liquid), 4-(2,3-epoxypropan-1-yloxy)-N,N-bis(2,3-epoxypropan-1-yl)-2-methylaniline, glycidyl methacrylate, alkyl phenol monoglycidyl ether, flexible and tough liquid epoxy resin EXA-4850-150 (manufactured by DIC Corporation), Rikaresin BEO-60E (manufactured by New Japan Chemical co., ltd.), etc.

The cationic polymerizable compound being other than the component (A) and having a glycidyl ether structure of the component (B) has an epoxy equivalent of 100 to 300 g/eq preferably, and of 120 to 300 g/eq more preferably. The cationic polymerizable compound of the component (B) is preferably liquid at normal temperature.

The cationic polymerizable compound of the component (B) can be synthesized with reference to known methods (for example, Japanese Patent Application Publication No. 2001-39960; and Jikken Kagaku Kouza (the 4th Series of Experimental Chemistry) 28, p. 428). In addition, commercially available products can also be used. For example, specific examples of the commercially available products include sorbitol polyglycidyl ether products such as, for example, Denacol EX-611 (epoxy equivalent: 167 g/eq), Denacol EX-612 (epoxy equivalent: 166 g/eq), Denacol EX-614 (epoxy equivalent: 167 g/eq), and Denacol EX-614B (epoxy equivalent: 173 g/eq) manufactured by Nagase ChemteX Corporation; and ERISYS GE-60 (epoxy equivalent: 160 to 195 g/eq) manufactured by Emerald Performance Materials.

The content of the cationic polymerizable compound of the component (B) is 5 to 70% by mass, preferably 20 to 60% by mass, and more preferably 30 to 50% by mass in the total amount of the composition for optical stereolithography. If the content of the cationic polymerizable compound of the component (B) is less than 5% by mass, a stereo lithographic object formed from the composition has an insufficient flexibility. If the content exceeds 70% by mass, the cured thin film layers weakly cohere to one another. The cured thin film layers favorably cohering to one another improves the warp deformation in the process of fabricating a stereo lithographic object, making it possible to enhance mechanical properties such as tensile strength, elongation, bending strength, and bending modulus of the obtained stereo lithographic object.

The composition for optical stereolithography may further contain another cationic polymerizable compound in addition to the cationic polymerizable epoxy resin of the component (A) and the cationic polymerizable compound being other than the component (A) and having a glycidyl ether structure of the component (B). The other cationic polymerizable compound mentioned above is preferably a multifunctional monomer having two or more cationic polymerizable bonds in one molecule. The other cationic polymerizable compound is, for example, a cationic polymerizable compound having an epoxy group, a vinyl ether group, or an oxetane group. This cationic polymerizable compound having an epoxy group is other than the cationic polymerizable epoxy resin of the component (A).

Specific examples of the cationic polymerizable compound having an epoxy group include hexahydrophthalic acid diglycidyl ester (epoxy equivalent: 155 g/eq, SR-HHPA, manufactured by Sakamoto Yakuhin Kogyo Co., Ltd.), 3,4-epoxycyclohexylmethyl methacrylate (epoxy equivalent: 195 to 215 g/eq, CYCLOMER M100, manufactured by Daicel Corporation), a condensation product of 1,2-epoxy-4-(2-oxiranyl)cyclohexane of 2,2-bis(hydroxy methyl)-1-butanol (epoxy equivalent: 170 to 190 g/eq, EHPE 3150, manufactured by Daicel Corporation), epoxidized polybutadiene (epoxy equivalent: 152 to 178 g/eq, EPOLEAD PB4700, manufactured by Daicel Corporation), ε-caprolactone modified tetra(3,4-epoxycyclohexylmethyl)butanetetracarboxylate (epoxy equivalent: 200 to 400 g/eq, EPOLEAD GT401, manufactured by Daicel Corporation), and so on.

Specific examples of the cationic polymerizable compound having a vinyl ether group include cyclopentadiene vinyl ether, tricyclodecane vinyl ether, benzyl vinyl ether, 1,4-butanediol divinyl ether, cyclohexane dimethanol divinyl ether, diethylene glycol divinyl ether, triethylene glycol divinyl ether, oxetane divinyl ether, 4-cyclohexane divinyl ether, oxanorbornane divinyl ether, and the like.

Specific examples of the cationic polymerizable compound having an oxetane group include (3-ethyl-oxetan-3-yl)-methanol, 3 -(3 -ethyl-oxetan-3 -ylmethoxy)-propan-1 -ol, 4-(3-ethyl-oxetan-3-ylmethoxy)-butan-1-ol, 3-(3-ethyl-oxetan-3-ylmethoxy)-propane-1,2-diol, 1-(3-ethyl-oxetan-3-ylmethoxy)-propan-2-ol, 1-[2-(3-ethyl-oxetan-3-ylmethoxy)-1-methyl-ethoxy-ethanol, 2-[2-(3-ethyl-oxetan-3-ylmethoxy)-ethoxy]-ethanol xylylene bisoxetane, 3-ethyl-3[([3-ethyloxetan-3-yl]methoxy]methyl]oxetane, 2-ethylhexyloxetane, 1,4-benzenedicarboxylic acid bis[(3-ethyl-3-oxetanyl)methyl]ester, (3-ethyl-3-oxetanyl)methoxymethyl methacrylate, 4,4-bis(3-ethyl-3-oxetanyl)methoxymethyl)biphenyl, 3-ethyl-3-(vinyloxymethyl)oxetane, 3,4-epoxycyclohexylmethyl 3,4-epoxycyclohexane carboxylate, ε-caprolactone modified 3,4-epoxycyclohexylmethyl 3,4-epoxycyclohexylsuncarboxylate, and the like.

One of the cationic polymerizable compounds having an epoxy group, a vinyl ether group, or an oxetane group can be used alone, or two or more thereof can be used in combination.

As the cationic polymerizable compounds having an epoxy group, a vinyl ether group, or an oxetane group, commercially available products can be used. Examples thereof include Crossmer manufactured by Nippon Carbide Industries Co., Inc., Celloxides and Epoleads manufactured by Daicel Corporation, vinyl ethers manufactured by Maruzen Petrochemical Co., Ltd., Sumi-Epoxy manufactured by Sumitomo Chemical Co., Ltd., and the like.

The content of the cationic polymerizable compound(s) other than the component (A) and the component (B) is preferably lower than the total content of the cationic polymerizable compounds of the component (A) and the component (B), and is preferably 1 to 30% by mass, and more preferably 1 to 20% by mass in the total amount of the composition for optical stereolithography. Incorporating one or more cationic polymerizable compounds having an epoxy group, a vinyl ether group, or an oxetane group within the above range makes it possible to adjust properties of the cured product such as tensile strength, warp deformation, and bending strength. Moreover, the cationic polymerizable compound having an oxetane group has an effect of enhancing the curing rate of the cationic polymerizable compounds. This speeds up the production of the stereolithographic object using the composition for optical stereolithography, enabling the production at high stereolithographic speed with high productivity.

The component (C) is a radical polymerizable compound having a methacrylic group and/or an acrylic group. As for the component (C) in an uncured state, the solubility into water at normal temperature (25°C) is preferably 5 g/100 ml or more, more preferably 40 g/100 ml or more, and further preferably 50 g/100 ml or more. The radical polymerizable compound of the component (C) is preferably liquid at normal temperature. Hereinafter, the methacrylic group or acrylic group will also be referred to as "(meth)acryloyl group," and a methacrylate or acrylate will also be referred to as "(meth)acrylate".

The radical polymerizable compound having a methacrylic group and/or an acrylic group of the component (C) may have one, two, three, or more functional groups. The component (C) is preferably miscible with the cationic polymerizable compound of the component (B). Specific examples of each include the following compounds.

The monofunctional compound includes (meth)acryloylmorpholine, 2-hydroxyethyl (meth)acrylate, 2-hydroxypropyl (meth)acrylate, polyethylene glycol mono(meth)acrylate, polyethylene glycol mono(meth)acrylate, glycerol (meth)acrylate, nonylphenol EO-modified (meth)acrylate, a reaction product between 2-hydroxyethyl (meth)acrylate and phosphoric anhydride, a reaction product between a hexalide addition polymer of 2-hydroxyethyl (meth)acrylate and phosphoric anhydride, and the like.

The bifunctional compound includes triethylene glycol di(meth)acrylate, tetraethylene glycol di(meth)acrylate, polyethylene glycol (400) di(meth)acrylate, polyethylene glycol (600) di(meth)acrylate, polypropylene glycol (400) di(meth)acrylate, ethoxylated (4) bisphenol A di(meth)acrylate, ethoxylated (10) bisphenol A di(meth)acrylate, ethoxylated (30) bisphenol A di(meth)acrylate, ethoxylated (4) hydrogenated bisphenol A di(meth)acrylate, ethoxylated (30) hydrogenated bisphenol A di(meth)acrylate, EO-modified (10) hydrogenated bisphenol A di(meth)acrylate, and the like.

The compound having three or more functional groups includes ethoxylated (9) glycerol tri(meth)acrylate, ethoxylated (20) glycerol tri(meth)acrylate, polyether-based urethane trifunctional (meth)acrylate, and the like.

The radical polymerizable compound having a methacrylic group and/or an acrylic group of the component (C) can be synthesized by known methods. In addition, commercially available products can be used. Examples thereof include Aronix series manufactured by Toagosei Co., Ltd., BLEMMER series manufactured by NOF Corporation, Light Ester series, Light Acrylate series, Epoxy Ester series, and Urethane Acrylate series manufactured by Kyoeisha Chemical Co., Ltd., NK Ester series and NK Oligo series manufactured by Shin Nakamura Chemical Co., Ltd., KAYARAD series manufactured by Nippon Kayaku Co., Ltd., Viscoat series manufactured by Osaka Organic Chemical Industry Ltd., etc.

The content of the radical polymerizable compound of the component (C) is 5 to 50% by mass and preferably 10 to 40% by mass in the total amount of the composition for optical stereolithography. Containing the radical polymerizable compound of the component (C), the composition enables faster stereolithographic shaping than a composition not containing the component (C). Furthermore, if the content of the radical polymerizable compound of the component (C) is less than 5% by mass, the sensitivity is insufficient. If the content exceeds 50% by mass, the cured product is not tough.

The content of the radical polymerizable compound of the component (C) is preferably lower than the content of the cationic polymerizable compound of the component (B). Setting the content of the radical polymerizable compound of the component (C) lower than the content of the cationic polymerizable compound of the component (B) makes it possible to enhance the hardness of the cured product.

In addition to the radical polymerizable compound of the component (C), the composition for optical stereolithography can further contain another radical polymerizable compound. The content of the other radical polymerizable compound is preferably 5 to 30% by mass in the total amount of the composition for optical stereolithography.

Specific examples of a monofunctional monomer of the other radical polymerizable compound include, for example, acrylamide, 7-amino-3,7-dimethyloctyl (meth)acrylate, isobutoxymethyl (meth)acrylamide, isobornyl (meth)acrylate, 2-ethylhexyl (meth)acrylate, diacetone (meth)acrylamide, dimethylaminoethyl (meth)acrylate, diethylaminoethyl (meth)acrylate, lauryl (meth)acrylate, dicyclopentenyloxyethyl (meth)acrylate, dicyclopentenyl(meth)acrylate, N,N-dimethyl(meth)acrylamide, tetrahydrofurfuryl (meth)acrylate, vinylcaprolactam, N-vinylpyrrolidone, phenoxyethyl (meth)acrylate, butoxyethyl(meth)acrylate, pentachlorophenyl(meth)acrylate, pentabromophenyl (meth)acrylate, polyethylene glycol mono(meth)acrylate, polypropylene glycol mono(meth)acrylate, isobornyl (meth)acrylate, etc.

Specific examples of a bifunctional monomer of the other radical polymerizable compound include, for example, ethylene glycol di(meth)acrylate, tricyclodecanediyldimethylene di(meth)acrylate, tripropylene glycol di(meth)acrylate, neopentyl glycol di(meth)acrylate, bisphenol A diglycidyl ether with (meth)acrylic acid added to both ends, 1,4-butanediol di(meth)acrylate, 1,6-hexanediol di(meth)acrylate, polyester di(meth)acrylate, polyester-based urethane bifunctional (meth)acrylate, etc.

Specific examples of a trifunctional or more multifunctional monomer of the other radical polymerizable compound include, for example, tris(acryloyloxyethyl)isocyanurate, trimethylolpropane tri(meth)acrylate, EO-modified trimethylolpropane tri(meth)acrylate, PO-modified trimethylolpropane tri(meth)acrylate, pentaerythritol tri(meth)acrylate, dipentaerythritol hexa(meth)acrylate, dipentaerythritol penta(meth)acrylate, ditrimethylolpropane tetra(meth)acrylate, dipentaerythritol monohydroxy penta(meth)acrylate, caprolactone-modified dipentaerythritol hexa(meth)acrylate, caprolactone-modified dipentaerythritol penta(meth)acrylate, polyether-based urethane trifunctional (meth)acrylate, ethoxylated isocyanuric acid tri(meth)acrylate, and the like.

The component (D) is a styrene-containing copolymer resin that is a copolymer resin of styrene and maleic anhydride in which, in the repeating unit including the styrene unit and the maleic anhydride unit, the maleic anhydride unit is half-esterified by ring-opening with an alcohol or the like to form ester and carboxylic acid, and/or that is a copolymer resin of styrene and methacrylic acid or acrylic acid. Here, "a copolymer resin of styrene and maleic anhydride" is a resin having a molar ratio of styrene units to maleic anhydride units of preferably 1:1 to 8:1, and some or all of the maleic anhydride units (for example, 80 to 100 mol%) are cleaved to be half-esterified, that is, to form ester and carboxylic acid. The alcohol-derived portion of the ester is preferably an alkyl group having 1 to 18 carbon atoms such as methyl, ethyl, propyl, isopropyl, butyl, isobutyl, and 2-ethylhexyl. Furthermore, "a copolymer resin of styrene and methacrylic acid or acrylic acid" is a resin obtained by copolymerizing styrene and methacrylic acid or acrylic acid. The acid value of such styrene-containing copolymer resin is preferably in the range of 120 to 250 mg KOH/g. Further, the molecular weight of the styrene-containing copolymer resin is preferably in the range of 7,000 to 30,000. The acid value of the styrene-containing copolymer resin can be measured, for example, based on JIS K0070 (Test method for acid value of chemical products). The molecular weight of the styrene-containing copolymer resin can be measured, for example, as a weight average molecular weight by using gel permeation chromatography (GPC) in terms of polystyrene.

Specific examples of the copolymer resin of styrene and maleic anhydride, which is a copolymer resin in which the maleic anhydride unit in a repeating unit including the styrene unit and the maleic anhydride unit is half-esterified, include SMA 1440 (acid value: 165 to 205 mg KOH/g, molecular weight: 7,000), SMA 17352 (acid value: 255 to 285 mg KOH/g, molecular weight: 7,000), SMA 2625 (acid value: 200 to 240 mg KOH/g, molecular weight: 9,000), and SMA 3840 (acid value: 95 to 120 mg KOH/g, molecular weight: 10,500), manufactured by KAWAHARA PETROCHEMICAL CO., LTD; HIROS US-1243 (acid value: 180 to 200 mg KOH/g, molecular weight: 5,500 to 7,600), HIROS X-200 (acid value: 180 to 200 mg KOH/g, molecular weight: 10,000 to 14,000), HIROS X-205 (acid value: 240 to 260 mg KOH/g, molecular weight: 10,000 to 14,000), HIROS X-220 (acid value: 145 to 165 mg KOH/g, molecular weight: 11,000 to 15,000), and HIROS X-228 (acid value: 130 to 150 mg KOH/g, molecular weight: 14,000 to 18,000) manufactured by SEIKO PMC CORPORATION; ARASTAR 700 (acid value: 175 to 200 mg KOH/g, molecular weight: 10,000) manufactured by Arakawa Chemical Industries, Ltd., etc.

Specific examples of the copolymer resin of styrene and methacrylic acid or acrylic acid include HIROS VS-1047 (acid value: 230 to 250 mg KOH/g, molecular weight: 8,000 to 12,000) manufactured by SEIKO PMC CORPORATION, ARUFON UC-3080 (acid value: 230 mg KOH/g, molecular weight: 14,000), and ARUFON UF-5022 (acid value: 235 mg KOH/g, molecular weight: 14,000) manufactured by TOAGOSEI CO., LTD.; Joncryl 67 (acid value: 213 mg KOH/g, molecular weight: 12,500), Joncryl 678 (acid value: 215 mg KOH/g, molecular weight: 8,500), Joncryl 680 (acid value: 215 mg KOH/g, molecular weight: 4,900), Joncryl 682 (acid value: 238 mg KOH/g, molecular weight: 1,700), and Joncryl 690 (acid value: 240 mg KOH/g, molecular weight: 16,500) manufactured by BASF SE, etc.

The content of the styrene-containing copolymer resin of the component (D) is 1 to 30% by mass and is preferably 3 to 20% by mass in the total amount of the composition for optical stereolithography. If the content is less than 1% by mass, a stereolithographic object formed from the composition has insufficient mechanical strength. If the content exceeds 30% by mass, production of a composition for optical stereolithography has difficultly in dispersing or dissolving the component (D) in the composition. When a predetermined amount of the component (D) is added to a composition for optical stereolithography, a stereolithographic object formed from the composition can have improved mechanical strength.

The component (E) is cationic polymerization initiator that is a sulfonium compound or a bis(alkylphenyl)iodonium compound. Specific examples of the cationic polymerization initiator of the component (E) include bis[4-n-alkyl(C10 to 13)phenyl]iodonium hexafluorophosphate, bis(4-tert-butylphenyl)iodonium bis(perfluorobutanesulfonyl)imide, bis(4-tert-butylphenyl)iodonium hexafluorophosphate, bis[4-n-alkyl(c10 to 13)phenyl]iodonium tetrakis pentafluorophenyl borate, diphenyl[4-(phenylthio)phenyl]sulfonium hexafluorophosphate, 4,4-bis(diphenylsulfonyl)phenyl sulfide-bis-hexafluorophosphate, benzidylmethyl-P-hydroxyphenylsulfonium hexafluoroantimonate, and the like.

As the cationic polymerization initiator of the component (E), commercially available products can be used. Examples thereof include San-Aid SI series manufactured by Sanshin Chemical Industry Co., Ltd., WPI series manufactured by Wako Pure Chemical Industries, Ltd., SP series manufactured by Adeka Corporation, CPI series manufactured by San-Apro Ltd., and the like.

The content of the cationic polymerization initiator of the component (E) is within a range of 0.1 to 20% by mass and preferably within a range of 0.5 to 10% by mass in the total amount of the composition for optical stereo lithography. If the content is less than 0.1% by mass, the cationic polymerization reaction rate is low. If the content exceeds 20% by mass, the composition for optical stereo lithography has low curing properties.

The component (F) is a radical polymerization initiator. The radical polymerization initiator is not particularly limited, as long as the compound is capable of starting a radical reaction of the radical polymerizable compound by generating radical species when irradiated with an activation energy ray. Specific examples of the radical polymerization initiator include 2,2-dimethoxy-1,2-diphenylethan-1-one, 1-hydroxycyclo hexyl phenyl ketone, 2-hydroxy-2-methyl-1 -phenyl-propan-1-one, 1-[4-(2-hydroxyethoxy)-phenyl]-2-hydroxy-2-methyl-1-propan-1-one, 2-hydroxy-1-[4-[4-(2-hydroxy-2-methyl-propionyl)-benzyl]phenyl]-2-methyl-propan-1-one, phenylglyoxylic acid methyl ester, 2-methyl-1 -(4-methylthiophenyl)-2-morpholinopropan-1-one, 2-benzyl-dimethylamino-1-(4-morpholinophenyl)-butane-1, 2-(dimethylamino)-2-[(4-methylphenyl)methyl]-1-[4-(4-morpholinyl)phenyl]-1-butane, 2,4,6-trimethylbenzoyl-diphenyl-phosphine oxide, bis(2,4,6-trimethylbenzoyl)-phenylphosphine oxide, bis(η5-2,4-cyclopentadiene-1-yl)-bis(2,6-difluoro-3-(1H-pyrrol-1-yl)-phenyl)titanium, 1,2-octanedione-1-[4-(phenylthio)-2-(O-benzoyloxime)], ethanone,1-[9-ethyl-6-(2-methylbenzoyl)-9H-carbazol-3-yl]-1-(O-acetyloxime), camphorquinone, benzophenone, 2-hydroxy-2-methyl-1-phenyl-1-propane, 4,4-bis(diethylamino)benzophenone, ethyl 4-(dimethylamino)benzoate, [4-(methylphenylthio)phenyl]-phenylmethane, ethylhexyl-4-dimethylaminobenzoate, methyl 2-benzoylbenzoate, 4-methylbenzophenone, camphorquinone, tetrabutylammonium butyltriphenylborate, tetrabutylammonium butyltrinaphthylborate, 2-ethyl-4-methylimidazolium tetraphenylborate, 1,5-diazabicyclo[4.3.0]nonene-5-tetraphenylborate, and the like. One of the radical polymerization initiators can be used alone, or two or more thereof can be used in combination.

As the radical polymerization initiator of the component (F), commercially available products can be used. Examples thereof include IRGACURE series, DAROCUR series, and LUCIRIN series manufactured by BASF SE, SB-PI series of SORT Co., Ltd., Adeka Optomer series manufactured by Adeka Corporation, organoboron compound series manufactured by Showa Denko K.K., organoboron compound series manufactured by Hokko Chemical Industry Co., Ltd., etc.

The content of the radical polymerization initiator of the component (F) is within a range of 0.1 to 20% by mass, preferably within a range of 0.5 to 10% by mass, in the total amount of the composition for optical stereolithography. If the content is less than 0.1% by mass, the radical polymerization reaction rate of the composition for optical stereolithography is slow. If the content exceeds 20% by mass, the composition for optical stereolithography has low curing properties.

The component (G) is a sensitizer. The sensitizer is not particularly limited, as long as the compound is capable of increasing the photosensitivity of the composition for optical stereolithography (the compound is conceivably capable of absorption at a wavelength of preferably 300 to 500 nm), but a multifunctional thiol compound is preferable. Specific examples of the multifunctional thiol compound include 1,3,5-tris(3-mercaptobutyryloxyethyl)-1,3,5-triazine-2,4,6(1H,3H,5H)-trione, 1,4-bis(3-mercaptobutyryloxy)butane, pentaerythritol tetrakis(3 -mercaptobutylate), trimethylolpropane tris(3 -mercaptopropionate), tris[(3-mercaptopropionyloxy)-ethyl]-isocyanurate, pentaerythritol tetrakis(3-mercaptopropionate), and the like. Commercially available multifunctional thiol compound can be used as the sensitizer of the component (G). Examples thereof include QX40 manufactured by Mitsubishi Chemical Corporation, Adeka Hardener EH-317 manufactured by Adeka Corporation, PEMP, TBMPIC, and TMPMP manufactured by SC Organic Chemical Co., Ltd., KarenzMT series manufactured by Showa Denko K.K., and the like.

Specific examples of sensitizers other than the multifunctional thiol compound include benzophenone; acridines such as 9-phenylacridine, 9-(p-methylphenyl)acridine, 9-(o-methylphenyl)acridine, 9-(o-chlorophenyl)acridine, and 9-(o-fluorophenyl)acridine; coumarins such as 7,7-(diethylamino)(3,3-carbonylbiscoumarin), 3-benzoyl-7-diethylaminocoumarin, and 7,7-bis(methoxy)(3,3-carbonylbiscoumarin); anthracenes such as 9,10-dimethoxyanthracene, 9,10-ethoxyanthracene, and 9,10-butoxyanthracene, etc.

The content of the sensitizer of the component (G) is within a range of 0.05 to 5.0% by mass and preferably within a range of 3 to 5% by mass in the total amount of the composition for optical stereolithography. If the content exceeds 5.0% by mass, the sensitivity is locally decreased, or the curing occurs only on a part of the surface. Adding the component (G) to the composition for optical stereolithography further promotes the photo-curing reaction, and all the polymerizable components in the composition are cured (linked). This makes it possible to obtain sufficient mechanical strength and heat resistance of a stereolithographic object formed from the composition.

The composition for optical stereolithography can contain a solvent for dissolving or dispersing the component (E) and/or the component (F), a curing accelerator, a colorant, and the like as other components within such ranges that the properties of the composition for optical stereolithography are not adversely influenced. Those skilled in the art can adjust the contents of the other components as appropriate.

The composition for optical stereolithography contains: 5 to 50% by mass of the cationic polymerizable epoxy resin of the component (A), 5 to 70% by mass of the cationic polymerizable compound of the component (B) other than the component (A), 5 to 50% by mass of the radical polymerizable compound of the component (C), 1 to 30% by mass of the styrene-containing copolymer resin of the component (D), 0.1 to 20% by mass of the cationic polymerization initiator of the component (E), 0.1 to 20% by mass of the radical polymerization initiator of the component (F), and 0.05 to 5.0% by mass of the sensitizer of the component (G), and optionally further contains another cationic polymerizable compound, another radical polymerizable compound, and/or another component. The total content of the cationic polymerizable epoxy resin of the component (A), the cationic polymerizable compound of the component (B), and the radical polymerizable compound of the component (C) is preferably 50% by mass or more, more preferably 60% by mass or more, and further preferably 65 to 95% by mass from the viewpoint of efficient production of cured objects.

The composition for optical stereolithography can be prepared according to conventional methods. For example, the composition for optical stereolithography can be prepared through steps of: stirring the components (A) to (G) and further another cationic polymerizable compound, another radical polymerizable compound, and/or other components, as necessary, to form a uniform mixture; filtering the mixture to remove foreign matters mixed in the raw materials and foreign matter mixed in the production process; and deaerating the mixture. The amounts of the components blended are set such that the final concentrations in the composition for optical stereolithography fall within the above-described ranges. In a case in which the components such as the components (C), (E), and (F) are solid at normal temperature, the components are each preferably dissolved or dispersed in a solvent in advance for use. The stirring is preferably performed at a temperature of 20 to 40°C for 1 to 2 hours. This is because a temperature less than 20°C may result in a decrease in the stirring efficiency due to increases in the viscosities of the polymerizable compounds, whereas a temperature exceeding 40°C may improve the stirring efficiency due to decreases in the viscosities but result in deterioration in the qualities of the photoinitiator and the polymerizable compounds. The composition for optical stereolithography prepared as described above is liquid at normal temperature (25°C). From the viewpoint of stereolithography, the composition for optical stereolithography preferably has a viscosity of approximately 200 to 1500 mPa·s at normal temperature.

Cured layers formed of the composition for optical stereolithography according to the present invention cohere to one another with an excellent cohesiveness. Hence, when the composition for optical stereolithography according to the present invention is cured using a stereolithography apparatus, the cured layers will not warp and become caught in the ultraviolet-laser operating machine and the like, so that the stereo lithographic object can be produced smoothly. Further, the composition for optical stereolithography makes it possible to produce a stereo lithographic object with a small warp deformation and a high dimensional precision. In addition, the stereolithographic object formed by curing the composition for optical stereolithography also has excellent mechanical properties, for example, tensile strength, elongation, bending strength, and bending modulus, in addition to the high dimensional precision.

The composition for optical stereolithography according to the present invention is suitably usable for optical stereolithography and applicable in a wide range of fields. Specific examples of the usage include, but are not limited to, high-precision parts, electrical and electronic parts, architectures, components for automobiles, dies, matrixes, medical holding devices such as orthopedic casts, mouthguards for stabilizing teeth, plastic objects created for dental care, medical plastic equipment, automobile parts, and the like. In addition, other specific examples of the usage include photo-curable inks, photo-curable coating materials, photo-curable adhesives, sealing agents, photo-curable sealing agents, composite agents, photo-curable ink jet, photo-curable microcapsules, photosensitive printing plates, photoresist inks, proofing agents for printing, hologram materials, artificial nails (gel nails), materials for producing resin accessories, and the like. For example, a photo-curable resin is conventionally used for an artificial nail (gel nail), and peeling a cured resin coating from the nail requires use of a treatment chemical such as a release agent or a solvent (acetone) to swell or dissolve the resin coating for removal. Use of the composition of the present invention makes it possible to physically peel off the resin coating from the nail without using the treatment chemical described above.

A stereo lithographic object can be produced from the composition for optical stereolithography according to the present invention by employing conventional optical stereolithographic methods and stereolithography apparatuses. The method for producing a stereo lithographic object includes, for example, the steps of: (a) forming a cured layer by selectively irradiating the surface of the above-described composition for optical stereolithography with an activation energy ray based on contour data created from data on a shape which is input by three-dimensional CAD and sliced into multiple layers of thin cross-sectional pieces; (b) further supplying the composition for optical stereolithography onto the cured layer; (c) performing a stacking operation of forming a new cured layer continuously on the above-described cured layer by selective irradiation with an activation energy ray as in step (a); and (d) repeating this stacking operation. These steps make it possible to provide an intended stereolithographic object. The thickness of the single or stacked cured layers can be set, for example, 20 to 200 µm. The smaller the thickness of the cured layers, the higher the stereolithographic precision. Nevertheless, the time and cost necessary for the production are increased. Hence, in consideration of the balance of these, the thickness can be adjusted as appropriate.

The stereolithography apparatus used for the production of a stereolithographic object from the composition for optical stereolithography is not particularly limited. Examples thereof include three-dimensional additive stereolithography apparatuses such as ATOMm-4000 (manufactured by CMET Inc.), DigitalWaX (registered trademark) 020X (manufactured by Sea Force Co., Ltd.), and ACCULAS (registered trademark) BA-85S (manufactured by D-MEC Ltd.).

Examples of the activation energy ray with which the composition for optical stereolithography is irradiated include ultraviolet, visible light, ionizing radiation, X-rays, electron beams, and the like. Ultraviolet light or visible light is preferable. The wavelength of the ultraviolet or visible light is preferably 300 to 500 nm. A light source of the ultraviolet or visible light includes diode-pumped solid-state lasers, carbon arc lamps, mercury lamps, metal halide lamps, xenon lamps, chemical lamps, white LEDs, and the like, but is not limited thereto. In particular, from the viewpoints of stereolithographic precision, curability, etc., a laser is preferably used.

The stereolithographic object according to the present invention is a stereolithographic object containing the above-described cured products of the composition for optical stereolithography, and is preferably a stereolithographic object prepared by stacking the cured layers formed by curing the composition for optical stereolithography. The stereolithographic object is produced, for example, by the above-described method for producing a stereolithographic object. Since the cured layers cohere to one another in the stereolithographic object according to the present invention, the created object has a small warp deformation and an enhanced dimensional precision in the production process. Further, the stereolithographic object is excellent in heat resistance and mechanical properties such as tensile strength, elongation, bending strength, and bending modulus.

### EXAMPLES

### PREPARATION OF COMPOSITIONS FOR OPTICAL STEREOLITHOGRAPHY

Compositions for optical stereolithography in Examples 1 to 9 and Reference Examples 1 to 8 and 10 to 14 were prepared according to the following procedure.

According to each formula shown in Tables 1 and 2, all the components were put into a stirring container and stirred at a temperature of 20 to 40°C for 2 hours to obtain a liquid composition. This liquid composition was filtered through a 10-micron filter bag (PO-10-PO3A-503, manufactured by Xinxiang D. King Industry Co., Ltd.) to remove foreign matter. The resultant was left standing overnight and then deaerated. Thus, a transparent liquid composition was obtained.

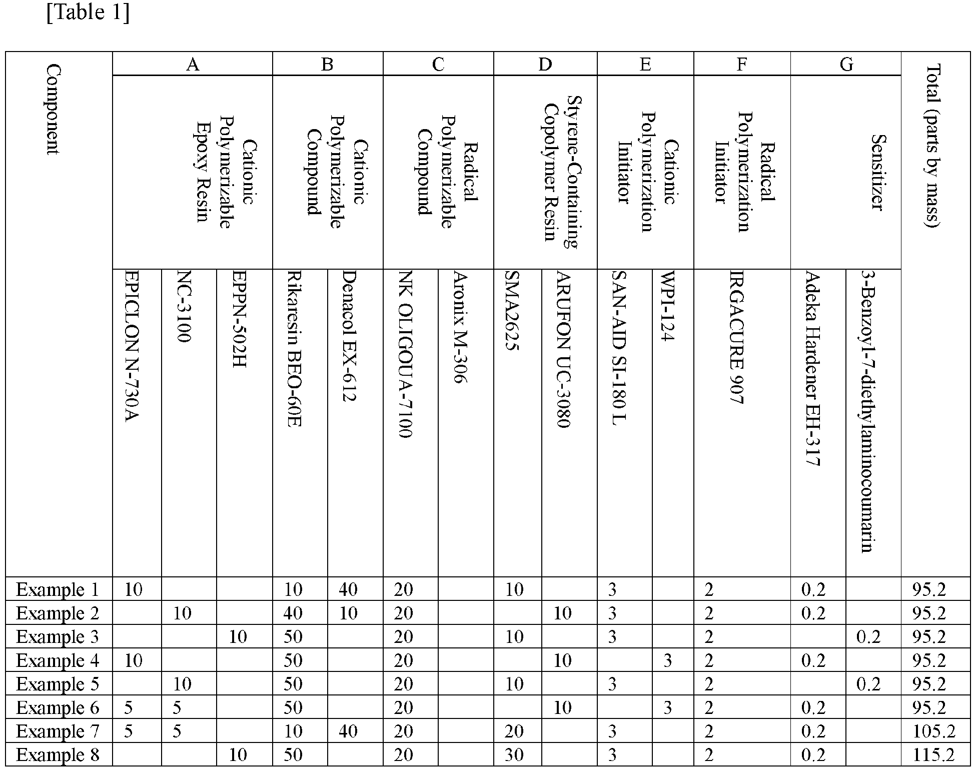

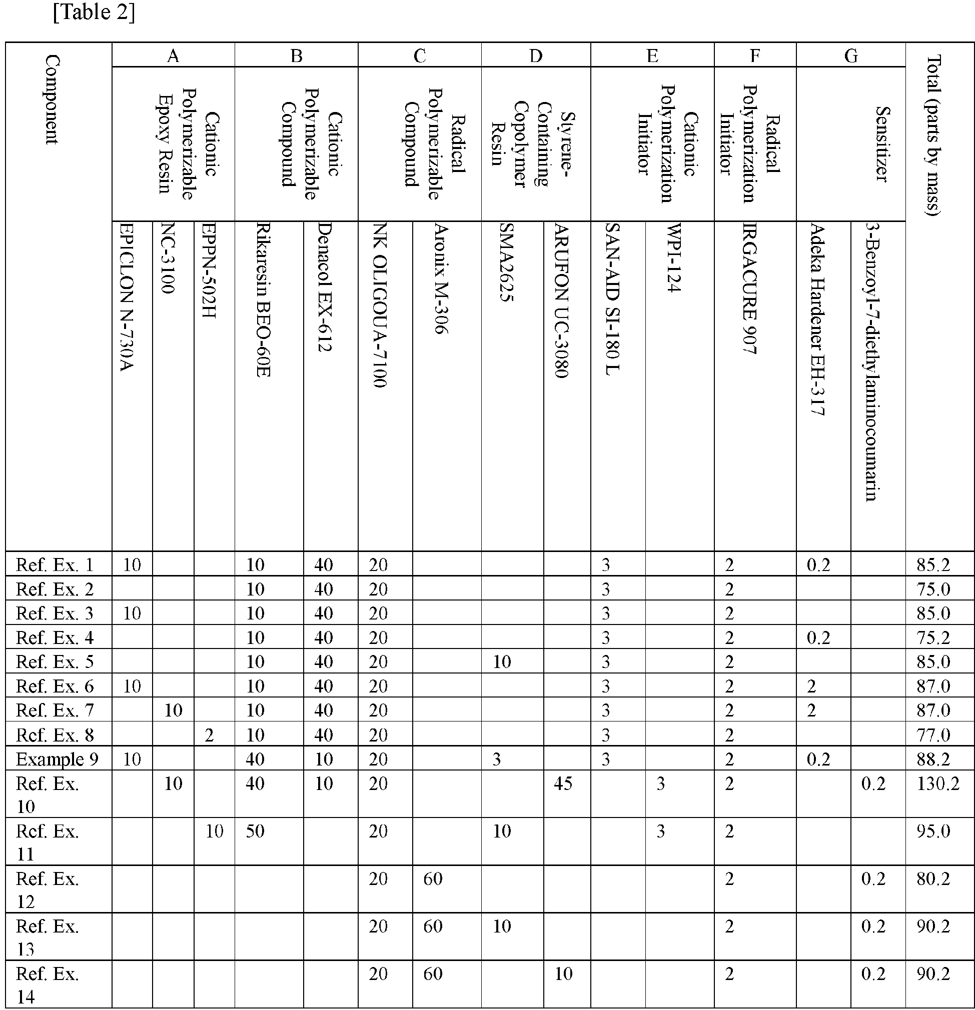

- EPICLON N-730A: novolac epoxy resin (epoxy equivalent: 175 g/eq) (manufactured by DIC Corporation),
- NC-3100: epoxy resin of the formula (I) of the component (A) (epoxy equivalent: 245 to 270 g/eq) (manufactured by Nippon Kayaku Co., Ltd.),
- EPPN-502H: epoxy resin of the formula (II) of the component (A) (epoxy equivalent: 158 to 178 g/eq) (manufactured by NIPPON STEEL & SUMIKIN CHEMICAL CO., LTD.),
- Denacol EX-612: sorbitol polyglycidyl ether (epoxy equivalent: 166 g/eq) (manufactured by Nagase ChemteX Corporation),
- Rikaresin BEO-60E: bisphenol A bis(triethylene glycol glycidyl ether)ether (n + m = 6) (manufactured by New Japan Chemical Co., Ltd.),
- NK Oligo UA-7100: urethane acrylate (manufactured by Shin Nakamura Chemical Co., Ltd.),
- Aronix M-306: a mixture of 65 to 70% of pentaerythritol triacrylate and 30 to 35% of pentaerythritol tetraacrylate (manufactured by TOAGOSEI CO., LTD.)
- SMA 2625: styrene/maleic anhydride half-ester copolymer resin (acid value: 200 to 240 mg KOH/g, molecular weight: 9,000) (manufactured by KAWAHARA PETROCHEMICAL CO., LTD),
- ARUFON UC-3080: styrene-(meth) acrylic acid copolymer resin (acid value: 230 mg KOH/g, molecular weight: 14,000) (manufactured by TOAGOSEI CO., LTD.),
- SAN-AID SI-180L: PF₆ based sulfonium salt (manufactured by SANSHIN CHEMICAL INDUSTRY CO., LTD.),
- WPI-124: bis[4- (alkyl C10 to C13) phenyl]iodonium tetrakis pentafluorophenyl borate (manufactured by Wako Pure Chemical Industries, Ltd.),
- IRGACURE 907: 2-methyl-1-(4-methylthiophenyl)-2-morpholinopropanone (manufactured by BASF SE)
- Adeka Hardener EH-317: a polymercaptan curing agent (manufactured by Adeka Corporation),
- Karenz MTNR 1: 1,3,5-tris(3-mercaptobutyryloxyethyl)-1,3,5-triazine-2,4,6 (1H,3H,5H)-trione (manufactured by Showa Denko K.K.), and
- 3-benzoyl-7-diethylaminocoumarin: (manufactured by NIKKO CHEM TECH CORPORATION).

The acid value and the weight average molecular weight of the styrene-containing copolymer resin of the component (D) were determined according to IS K0070 (Test method for acid value of chemical products) and gel permeation chromatography (GPC) in terms of polystyrene, respectively.

### FABRICATION OF EVALUATION SAMPLES 1

The following samples were fabricated to evaluate the curing times of the compositions for optical stereolithography.

The composition for optical stereolithography of Example 1 was poured into a handmade, rectangular polyethylene mold (a width of approximately 10 mm × a length of 100 mm with a depth of 5 mm) to form a 1-mm liquid film. Liquid films thus prepared were irradiated using a 3-kw high-pressure mercury lamp (wavelength: 365 nm, distance: 1 m) for 5 seconds, 10 seconds, 15 seconds, 20 seconds, 25 seconds, and 30 seconds. Thus, evaluation samples were obtained. The compositions for optical stereolithography of Examples 2 to 9 and Reference Examples 1 to 8 and 10 to 14 were also treated in the same manner, and evaluation samples thereof were obtained.

### FABRICATION OF EVALUATION SAMPLES 2

The following samples were fabricated in order to be evaluated as optical stereolithographic objects.

The composition for optical stereolithography of Example 1 was poured into a handmade, rectangular polyethylene mold (a width of approximately 10 mm × a length of 100 mm with a depth of 5 mm) to form a 1-mm liquid film, and irradiated using a 3-kw high-pressure mercury lamp (wavelength: 365 nm, distance: 1 m) for 20 seconds, which were repeated four times in total. Thus, a flat plate (a width of approximately 10 mm × a length of 100 mm) having a thickness of approximately 4 mm was fabricated. Further, the flat plate was irradiated again for 30 minutes to obtain an optical stereolithographic object. The compositions for optical stereolithography of Examples 2 to 9 and Reference Examples 1 to 8 and 10 to 14 were also treated in the same manner, and optical stereolithographic objects were obtained, respectively.

### EVALUATION METHOD

### 1) Evaluation of Curing Times of Compositions for Optical Stereolithography

Using the evaluation samples 1, the surface states of the samples were observed in ascending order of the irradiation time, and the irradiation time at which a tuck disappeared from the surface was determined as the curing time. Note that, regarding a tuck on the surface, the presence or absence of a tuck was judged as follows: each of the evaluation samples 1 was placed and treated in an oven at 35°C for 30 minutes, and cooled to room temperature (25°C), and then the surface was pushed with a polyester film by hand; then the sample was determined as having a tuck if the polyester film was not easily peeled, whereas the sample was determined as having no tuck if the polyester film was easily peeled.

### 2) Layer (Side Surface) Observation of Optical Stereolithographic Objects

Using the evaluation samples 2, the layers (side surfaces) of the flat plates were measured using a JSM-5600 scanning electron microscope manufactured by JEOL Ltd. (acceleration voltage: 7 kv, magnification: 200×). The evaluation criteria were: ("F") a gap was clearly seen between the layers; ("B") a gap between the layers was small; ("A") no gap but a line was seen between the layers; and ("AA") the layers were integrated so much as to be undistinguishable.

### 3) Warp Deformation Observation of Optical Stereolithographic Objects

Using the evaluation samples 2, each of the flat plates was placed on a flat stage, and a distance of an edge of the flat plate lifted up from the flat stage was measured. The judgment criteria were: ("F") the distance was 2 mm or more; ("B") the sample was lifted up at the distance of 2 mm or less; and ("A") the sample was at a distance of 0 mm without any lift.

### 4) Tensile Test

Using the evaluation samples 2, the tensile test of each of the flat plates was conducted to measure the tensile strength and elongation according to ISO 527-1 under the following measurement conditions. The elongation was measured as the maximum elongation ratio at break.
Measurement apparatus: universal testing system in 3366 model manufactured by Instron
Tensile speed (cross-head speed): 5 mm/min
Measurement environment: a temperature of 25°C, a humidity of 45% RH
Gauge length: 80 mm

### 5) Three-point Bending Test

Using the evaluation samples 2, the three-point bending test of the flat plates was conducted according to ISO 527-1 under the following measurement conditions to measure the bending strength and bending modulus.
Measurement apparatus: universal testing system in 3366 model manufactured by Instron
Test conditions: three-point bending test jig, indenter radius: 5 mm,
   support span: 64 mm,
   loading speed (cross-head speed) 2 mm/min)
Measurement environment: a temperature of 25°C, a humidity of 45% RH

**[Table 3]**

| | Evaluation Sample 1 | Evaluation Sample2 | | | | | |
|---|---|---|---|---|---|---|---|
| | Curing Time (Sec.) | Layer (Side Surface) Observation | Warp Deformation Observation | Tensile Strength (Mpa) | Elongation At Break (%) | Bending Strength (Mpa) | Bending Modulus (Mpa) |
| Example 1 | 10 | AA | A | 58 | 13 | 80 | 2240 |
| Example 2 | 10 | AA | A | 60 | 10 | 82 | 2330 |
| Example 3 | 10 | A | A | 68 | 8 | 91 | 2570 |
| Example 4 | 10 | A | A | 60 | 10 | 89 | 2535 |
| Example 5 | 10 | A | A | 62 | 10 | 95 | 2891 |
| Example 6 | 10 | A | A | 59 | 11 | 93 | 2990 |
| Example 7 | 10 | AA | A | 63 | 11 | 85 | 2480 |
| Example 8 | 10 | A | A | 59 | 13 | 80 | 2300 |
| Ref. Ex. 1 | 10 | A | A | 55 | 10 | 60 | 1880 |
| Ref. Ex. 2 | 20 | A | A | 39 | 10 | 45 | 1640 |
| Ref. Ex. 3 | 20 | A | A | 62 | 11 | 61 | 1860 |
| Ref. Ex. 4 | 10 | A | A | 37 | 13 | 43 | 1648 |
| Ref. Ex. 5 | 20 | A | A | 58 | 10 | 76 | 1845 |
| Ref. Ex. 6 | 30 | A | A | 60 | 13 | 45 | 1640 |
| Ref. Ex. 7 | 30 | A | A | 64 | 11 | 68 | 1890 |
| Ref. Ex. 8 | 20 | A | A | 38 | 11 | 44 | 1648 |
| Example 9 | 10 | AA | A | 61 | 12 | 60 | 1905 |
| Ref. Ex. 10 | 10 | AA | A | 60 | 13 | 64 | 1894 |
| Ref. Ex. 11 | 20 | A | A | 62 | 11 | 65 | 1900 |
| Ref. Ex. 12 | 10 | A | B | 28 | 18 | 38 | 1380 |
| Ref. Ex. 13 | 10 | A | B | 42 | 16 | 58 | 1550 |
| Ref. Ex. 14 | 10 | A | B | 45 | 15 | 62 | 1610 |

Table 3 shows the evaluation results of 1) to 5) described above. The curing times of the compositions for optical stereolithography of Examples were 10 seconds. The compositions were highly sensitive and the curing rates were high. This indicates that the curing densities are high. Moreover, the stereolithographic objects obtained by stacking the cured layers of the compositions for optical stereolithography of Examples were excellent in the mechanical properties such as a bending strength of 80 MPa or higher, and a bending modulus of 2240 MPa or higher. Furthermore, Reference Examples 12 to 14 also demonstrated improvements in the bending strength and the bending modulus even when the styrene copolymer resin is added to the compositions only containing the radical polymerizable compound(s).

## Claims

1. A composition for optical stereolithography, comprising
(A) a cationic polymerizable epoxy resin that is a novolac epoxy resin and/or an epoxy resin having a structure represented by
the following formula (I) 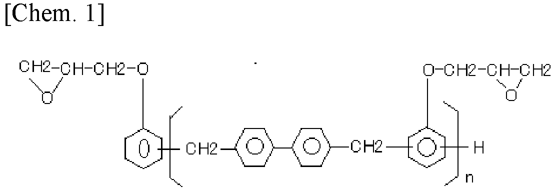 (in the formula, n represents an integer of 1 or more), or
the following formula (II) 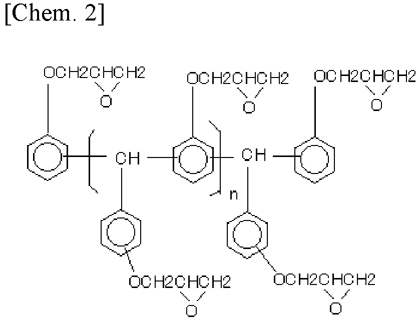 (in the formula, n represents an integer of 1 or more);
(B) a cationic polymerizable compound being other than the component (A) and having a glycidyl ether structure;
(C) a radical polymerizable compound having a methacrylic group and/or an acrylic group;
(D) a styrene-containing copolymer resin that is a copolymer resin of styrene and maleic anhydride, being the copolymer resin in which the repeating unit of the maleic anhydride is half-esterified by ring-opening to form ester and acid, and/or that is a copolymer resin of styrene and methacrylic acid or acrylic acid;
(E) a cationic polymerization initiator which is a sulfonium compound or a bis(alkylphenyl)iodonium compound;
(F) a radical polymerization initiator; and
(G) a sensitizer, wherein
the composition for optical stereolithography contains:
5 to 50% by mass of the cationic polymerizable epoxy resin of the component (A),
5 to 70% by mass of the cationic polymerizable compound of the component (B),
5 to 50% by mass of the radical polymerizable compound of the component (C),
1 to 30% by mass of the styrene-containing copolymer resin of the component (D),
0.1 to 20% by mass of the cationic polymerization initiator of the component (E),
0.1 to 20% by mass of the radical polymerization initiator of the component (F), and
0.05 to 5.0% by mass of the sensitizer of the component (G).

2. The composition for optical stereolithography according to claim 1, wherein the cationic polymerizable compound of the component (B) has an epoxy equivalent in a range of 100 to 300 g/eq.

3. The composition for optical stereolithography according to claim 1, wherein the styrene-containing copolymer resin of the component (D) has an acid value in a range of 120 to 250 mg KOH/g, measured based on JIS K0070, Test method for acid value of chemical products.

4. The composition for optical stereolithography according to claim 1, wherein the styrene-containing copolymer resin of the component (D) has a weight average molecular weight in a range of 7,000 to 30,000, measured using gel permeation chromatography in terms of polystyrene.

5. The composition for optical stereolithography according to claim 1, wherein the cationic polymerizable epoxy resin of the component (A) has an epoxy equivalent in a range of 100 to 300 g/eq.

## Patentansprüche

1. Zusammensetzung für optische Stereolithographie, umfassend
(A) ein kationisch polymerisierbares Epoxidharz, das ein Novolak-Epoxidharz und/oder ein Epoxidharz mit einer Struktur ist, die durch die folgende Formel (I) 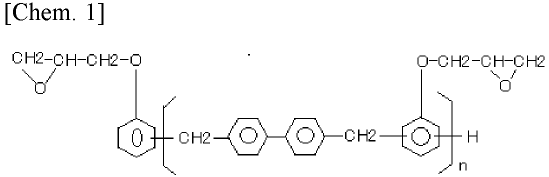 (in der Formel steht n für eine ganze Zahl von 1 oder mehr) oder die folgende Formel (II) dargestellt wird: 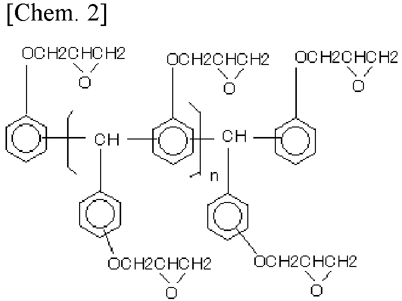 (in der Formel steht n für eine ganze Zahl von 1 oder mehr);
(B) eine kationisch polymerisierbare Verbindung, die nicht die Komponente (A) ist und eine Glycidyletherstruktur aufweist;
(C) eine radikalisch polymerisierbare Verbindung mit einer Methacrylgruppe und/oder einer Acrylgruppe;
(D) ein styrolhaltiges Copolymerharz, das ein Copolymerharz aus Styrol und Maleinsäureanhydrid ist, wobei es sich um das Copolymerharz handelt, in dem die Wiederholungseinheit des Maleinsäureanhydrids durch eine Ringöffnung zum Ausbilden von Ester und Säure zur Hälfte verestert ist, und/oder das ein Copolymerharz von Styrol und Methacrylsäure oder Acrylsäure ist;
(E) ein kationischer Polymerisationsinitiator, der eine Sulfoniumverbindung oder eine Bis(alkylphenyl)iodoniumverbindung ist;
(F) ein radikalischer Polymerisationsinitiator; und
(G) einen Sensibilisator, wobei die Zusammensetzung für optische Stereolithographie enthält:
5 bis 50 Massen-% des kationisch polymerisierbaren Epoxidharzes der Komponente (A),
5 bis 70 Massen-% der kationisch polymerisierbaren Verbindung der Komponente (B),
5 bis 50 Massen-% der radikalisch polymerisierbaren Verbindung der Komponente (C),
1 bis 30 Massen-% des styrolhaltigen Copolymerharzes der Komponente (D),
0,1 bis 20 Massen-% des kationischen Polymerisationinitiators der Komponente (E);
0,1 bis 20 Massen-% des radikalischen Polymerisationsinitiators der Komponente (F) und
0,05 bis 5,0 Massen-% des Sensibilisators der Komponente (G).

2. Zusammensetzung für optische Stereolithographie nach Anspruch 1, wobei die kationisch polymerisierbare Verbindung der Komponente (B) ein Epoxyäquivalent in einem Bereich von 100 bis 300 g/Äq.

3. Zusammensetzung für optische Stereolithographie nach Anspruch 1, wobei das styrolhaltige Copolymerharz der Komponente (D) einen Säurewert in einem Bereich von 120 bis 250 mg KOH/g aufweist, gemessen auf Grundlage von JIS K0070, Testverfahren für den Säurewert von chemischen Produkten.

4. Zusammensetzung für optische Stereolithographie nach Anspruch 1, wobei das styrolhaltige Copolymerharz der Komponente (D) ein gewichtsmittleres Molekulargewicht in einem Bereich von 7.000 bis 30.000 aufweist, gemessen unter Verwendung von Gelpermeationschromatographie in Bezug auf Polystyrol.

5. Zusammensetzung für optische Stereolithographie nach Anspruch 1, wobei das kationisch polymerisierbare Epoxidharz der Komponente (A) ein Epoxidäquivalent in einem Bereich von 100 bis 300 g/Äq aufweist.

## Revendications

1. Composition destinée à la stéréolithographie optique, comprenant
(A) une résine époxy polymérisable cationique qui est une résine époxy de type novolac et/ou une résine époxy ayant une structure représentée par la formule suivante (I) 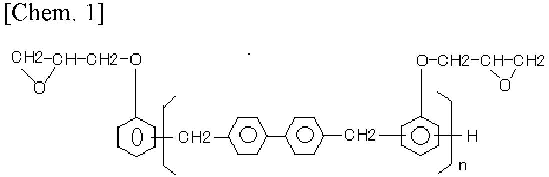 (dans la formule, n représente un nombre entier supérieur ou égal à 1), ou la formule suivante (II) 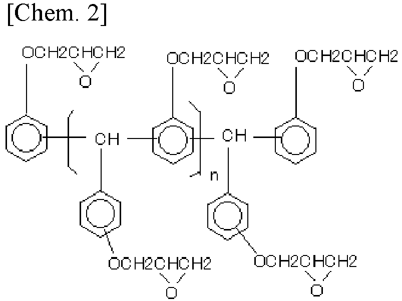 (dans la formule, n représente un nombre entier supérieur ou égal à 1) ;
(B) un composé polymérisable cationique étant différent du composant (A) et ayant une structure d'éther de glycidyle ;
(C) un composé polymérisable radicalaire ayant un groupe méthacrylique et/ou un groupe acrylique ;
(D) une résine de copolymère contenant du styrène qui est une résine de copolymère de styrène et d'anhydride maléique, étant la résine de copolymère dans laquelle le motif de répétition de l'anhydride maléique est à moitié estérifié par une ouverture de cycle afin de former l'ester et l'acide, et/ou qui est une résine de copolymère de styrène et d'acide méthacrylique ou d'acide acrylique ;
(E) un initiateur de polymérisation cationique qui est un composé de sulfonium ou un composé de bis(alkylphényl)iodonium ;
(F) un initiateur de polymérisation radicalaire ; et
(G) un sensibilisateur, dans laquelle la composition destinée à la stéréolithographie optique contient :
de 5 à 50 % en masse de la résine époxy polymérisable cationique du composant (A),
de 5 à 70 % en masse du composé cationique polymérisable du composant (B),
de 5 à 50 % en masse du composé polymérisable radicalaire du composant (C),
de 1 à 30 % en masse de la résine de copolymère contenant du styrène du composant (D),
de 0,1 à 20 % en masse de l'initiateur de polymérisation cationique du composant (E),
de 0,1 à 20 % en masse de l'initiateur de polymérisation radicalaire du composant (F), et
de 0,05 à 5.0 % en masse du sensibilisateur du composant (G).

2. Composition destinée à la stéréolithographie optique selon la revendication 1, dans laquelle le composé cationique polymérisable du composant (B) a un équivalent d'époxy dans la plage allant de 100 à 300 g/éq.

3. Composition destinée à la stéréolithographie optique selon la revendication 1, dans laquelle la résine de copolymère contenant du styrène du composant (D) possède un indice d'acide dans la plage allant de 120 à 250 mg KOH/g, mesuré en fonction de JIS K0070, le procédé d'essai pour l'indice d'acide des produits chimiques.

4. Composition destinée à la stéréolithographie optique selon la revendication 1, dans laquelle la résine de copolymère contenant du styrène du composant (D) a un poids moléculaire moyen en poids dans la plage allant de 7,000 à 30,000, mesuré par chromatographie d'exclusion stérique sur gel en termes de polystyrène.

5. Composition destinée à la stéréolithographie optique selon la revendication 1, dans laquelle la résine époxy polymérisable cationique du composant (A) a un équivalent d'époxy dans la plage allant de 100 à 300 g/éq.
